Europäisches Patentamt

European Patent Office

Office européen des brevets

(11) Publication number: **0 426 942 A1**

# EUROPEAN PATENT APPLICATION

(21) Application number: 90111021.3

(22) Date of filing: 11.06.90

(51) Int. Cl.⁵: **C11D 7/24**, C11D 3/18, C11D 3/43, C11D 7/50, B23K 35/00

(30) Priority: 08.11.89 JP 291903/89
08.11.89 JP 291904/89
09.01.90 JP 3149/90

(43) Date of publication of application:
15.05.91 Bulletin 91/20

(84) Designated Contracting States:
DE ES FR GB

(71) Applicant: ARAKAWA CHEMICAL INDUSTRIES, LTD.
3-7, Hiranomachi 1-chome
Chuo-ku, Osaka-shi, Osaka 541(JP)

(72) Inventor: Chihara, Machio
281-36, Ooaza-Kosaka, Tawaramoto-cho
Shiki-gun, Nara-ken(JP)
Inventor: Mizuya Jiro
Seiwa-Ryo, 1-5-38, Tsurumi, Tsurumi-ku
Osaka-shi, Osaka-fu(JP)
Inventor: Okumura, Tatsuya
Hogyoku-Ryo, 3-1-23, Moroguchi, Tsurumi-ku
Osaka-shi, Osaka-fu(JP)
Inventor: Tanaka, Takashi
Hogyoku-Ryo, 3-1-23, Moroguchi, Tsurumi-ku
Osaka-shi, Osaka-fu(JP)

(74) Representative: Barz, Peter, Dr. et al
Patentanwälte Dipl.-Ing. G. Dannenberg Dr.
P. Weinhold, Dr. D. Gudel Dipl.-Ing. S.
Schubert, Dr. P. Barz Siegfriedstrasse 8
W-8000 München 40(DE)

(54) Agent for cleaning rosin-base solder flux.

(57) Disclosed are a cleaning agent for removal of rosin-base solder fluxes, comprising a mixture of
(A) (i) (a) a hydrogenated fraction obtained by hydrogenating a fraction which has a boiling point of 150 to 300°C and which is formed as a by-product in the thermal decomposition or reforming of petroleum naphtha and/or (b) a hydrocarbon fraction formed as a by-product in the preparation of a hydrogenated petroleum resin obtained by hydrogenating a petroleum resin which is prepared by subjecting to cationic polymerization a fraction having a boiling point of 150 to 300°C and formed as a by-product in the thermal decomposition or reforming of petroleum naphtha,
(ii) tetralin, or
(iii) a hydrogenation product of a naphthalene oil fraction having a hydrogenation ratio of at least 20%; and
(B) a nonionic surfactant,
as well as a cleaning method for removal of rosin-base solder flux which comprises bringing the cleaning agent into contact with the rosin-base solder flux on a substrate.

## AGENT FOR CLEANING ROSIN-BASE SOLDER FLUX

The present invention relates to a cleaning agent for removal of rosin-base solder fluxes and more particularly to a cleaning agent for removal of rosin-base solder fluxes for assembly.

A rosin-base solder flux is used in production of modules for printed circuit boards, printed wiring boards or the like. Generally soldering is conducted to promote the union between the substrate and pins and to prevent oxidation in contact points which impairs electrical conductivity. Rosin-base fluxes are employed to accomplish the soldering as desired. After soldering, a cleaning agent is used to remove only the flux selectively and completely. When the cleaning agent fails to completely remove the flux, the remaining flux adversely affects the soldering, giving disadvantages of circuit corrosion, reduction of electrical insulating properties of board surfaces or eventual breakdown of circuits. To eliminate such potential disadvantages, it is significant to remove the residual flux, particularly the activator present therein by a proper cleaning agent.

Halogenated hydrocarbon solvents such as trichloroethylene, trichlorotrifluoroethane and the like have been heretofore used as cleaning agents for removal of rosin-base fluxes. However, stringent regulations for control of such halogenated hydrocarbon solvents have been laid down to solve or alleviate the environmental pollution problems such as the depletion of ozone layer. Currently there is an urgent demand also from the electric machine industry for development of cleaning agents for fluxes as a substitute for flons.

In recent years, various halogen-free cleaning agents for fluxes have been developed, but no cleaning agent has been provided which can completely fulfil all property requirements for cleaning agents including cleaning property, characteristics meeting the environmentally acceptable standard, inflammability, etc.

It is an object of the present invention to provide a halogen-free cleaning agent for removal of rosin-base fluxes which is excellent in a cleaning property and substantially satisfactory in characteristics meeting the environmental quality standard, inflammability, etc.

We conducted extensive research to achieve the foregoing object and found that the use of a specific hydrocarbon solvent and a nonionic surfactant as essential components can surprisingly obviate all the above-mentioned problems. We have accomplished the present invention based on this novel finding.

Stated more specifically, the present invention provides a cleaning agent for removal of rosin-base solder fluxes, the cleaning agent comprising a mixture of

(A) one of the following components (i) to (iii):

(i) (a) a hydrogenated fraction obtained by hydrogenating a fraction which has a boiling point of 150 to 300° C and which is formed as a by-product in the thermal decomposition or reforming of petroleum naphtha and/or (b) a hydrocarbon fraction formed as a by-product in the preparation of a hydrogenated petroleum resin obtained by hydrogenating a petroleum resin which is prepared by subjecting to cationic polymerization a fraction having a boiling point of 150 to 300° C and formed as a by-product in the thermal decomposition or reforming of petroleum naphtha,

(ii) tetralin, and

(iii) a hydrogenation product of naphthalene oil fraction having a hydrogenation ratio of at least 20%; and

(B) a nonionic surfactant.

The present invention also provides a cleaning method for removing a rosin-base flux, the method comprising bringing the above cleaning agent into contact with the rosin-base solder flux on a substrate.

The component (A) will be described below.

Of the component (A)-(i) of the cleaning agent for removing rosin-base solder fluxes according to the invention, the hydrogenated fraction (a) (hereinafter referred to as "component (a)") is known and obtained by hydrogenating a fraction which has a boiling point of 150 to 300° C and which is formed as a by-product in the thermal decomposition or reforming of petroleum naphtha. The component (a) thus obtained corresponds to a hydrogenated $C_9$ fraction obtained by hydrogenating a so-called $C_9$ fraction. The $C_9$ fraction is generally a mixture of hydrocarbons predominantly containing various polymerizable aromatic hydrocarbons such as styrene, $\alpha$-methylstyrene, vinyltoluene, vinylxylene, propenylbenzene, indene, methylindene, ethylindene and the like. The $C_9$ fraction may also contain a small quantity of aliphatic hydrocarbon such as butene, pentene, hexene, heptene, octene, butadiene, pentadiene, cyclopentadiene, dicyclopentadiene and the like. In brief, the component (a) is a mixture of hydrocarbons which predominantly comprises a saturated alicyclic hydrocarbon obtained by hydrogenation of the components of the $C_9$ fraction so as to hydrogenate substantially all the unsaturated bonds present therein by a known method and which may contain a small quantity of saturated aliphatic hydrocarbon. The hydrogenation reaction can be conducted by subjecting the $C_9$ fraction to reaction with heating under a hydrogen pressure of 0 to 300 kg/cm² at 30 to 300°C in the presence of nickel, palladium, cobalt, platinum, ruthenium, rhodium or like metal catalyst or a catalyst made of an oxide of these metals, giving the component (a) with ease. The hydrogenation is effected at the same temperature and under the same hydrogen pressure as above until the absorption of hydrogen reaches the predetermined level. When required, the hydrogenated fraction thus obtained is subjected to distillation or like treatment for removing the ingredients therein having a low boiling point or a low flash point. In this way, a hydrogenated fraction is prepared which has a flash point of about 50 to about 120°C, preferably about 70 to about 100°C.

Of the component (A)-(i) of the cleaning agent for removing rosin-base solder fluxes according to the invention, the hydrocarbon fraction (b) (hereinafter referred to as "component (b)") is known and formed as a by-product in the preparation of a hydrogenated petroleum resin produced by hydrogenating a petroleum resin which is obtained by subjecting to cationic polymerization a fraction having a boiling point of 150 to 300°C and formed as a by-product in the thermal decomposition or reforming of petroleum naphtha. The hydrogenated petroleum resin corresponds to a so-called hydrogenated $C_9$ petroleum resin which is prepared by polymerizing the $C_9$ fraction by a known cationic polymerization method to form a $C_9$ petroleum resin and then hydrogenating the $C_9$ petroleum resin by a known method. The method of cationic polymerization is not specifically limited and can be any of those conventionally employed, for example a method comprising reacting the $C_9$ fraction with heating in the presence of a Lewis acid catalyst such as boron trifluoride, anhydrous aluminum chloride or the like. Although the hydrogenation can be effected under the similar conditions to those employed with regard to the component (a), a severer condition is required as to hydrogen pressure and the reaction is usually carried out under a hydrogen pressure of about 50 to about 300 kg/cm². In view of the above, the component (b) is a so-called hydrogenated hydrocarbon fraction formed as a by-product in hydrogenation of a $C_9$ petroleum resin under the above hydrogenation conditions. When required, the hydrogenated hydrocarbon fraction is subjected to distillation or like treatment for removing the ingredients therein having a low boiling point or a low flash point. Thus, a hydrogenated hydrocarbon fraction is obtained which has a flash point of about 50 to about 120°C, preferably about 70 to about 100°C. The comparison between the components (a) and (b) shows that although the component (a) is somewhat different from the component (b) in that the latter contains a small quantity of hydrogenation products of dimers or oligomers of some components of the fraction used as a starting material, the two components (a) and (b) are considered to be substantially the same mixture of hydrocarbons.

The component (A)-(ii) of the cleaning agent for removing rosin-base solder fluxes according to the invention, i.e. tetralin is a colorless liquid having a boiling point of 207°C and a flash point of 77.2°C. Tetralin is usually prepared by a known process comprising hydrogenating naphthalene at about 150°C using a hydrogenation catalyst such as nickel, palladium, platinum or the like.

The hydrogenation product of naphthalene oil fraction used as the component (A)-(iii) of the cleaning agent of the present invention is known and is obtained by hydrogenating a fraction in coal tar, i.e. hydrogenating a liquid mixture of various hydrocarbons (naphthalene oil fraction) which has a boiling point of about 200 to about 250°C and which predominantly contains naphthalene, a lower alkyl naphthalene and the like so that the hydrogenation ratio becomes at least 20%. Preferably, the hydrogenation ratio is adjusted to at least 50%.

The term "hydrogenation ratio" used herein means a value calculated from the change in absorbance of ultraviolet light at 254 nm according to the following equation.

Hydrogenation ratio (%)

$$= \frac{A - A_1}{A} \times 100$$

wherein A is the absorbance of naphthalene oil fraction used as the starting material and $A_1$ is the absorbance of the hydrogenation product.

The naphthalene oil fraction is generally hydrogenated by a known method comprising hydrogenating the naphthalene oil fraction at about 150°C and at a hydrogen pressure of about 10 to 300 kg/cm² using nickel, palladium, platinum or like hydrogenating catalyst (see Reference Example 1 described hereinafter). Although it is difficult to specifically identify the compounds contained in the hydrogenation product obtained above, presumably the hydrogenation product predominantly contains decalin, tetralin, lower alkyl-substituted decalin, lower alkyl-substituted tetralin and the like. The hydrogenation product of naphthalene oil fraction thus obtained has a boiling point of about 200 to about 250°C and a flash point of about 80°C.

The component (B) will be described below.

The nonionic surfactant serving as the component (B) of the cleaning agent for removing rosin-base solder fluxes according to the invention is not specifically limited insofar as the surfactant is nonionic, and can be any of those conventionally known. Specific examples of such nonionic surfactant are polyoxyethylene alkyl ether, polyoxyethylene phenyl ether, polyoxyethylene alkylphenyl ether and like polyethylene glycol ether-based nonionic surfactants; polyethylene glycol monoester, polyethylene glycol diester and like polyethylene glycol ester-based nonionic surfactants; adduct of higher aliphatic amine with ethylene oxide; adduct of fatty acid amide with ethylene oxide; sorbitan fatty acid ester, sucrose fatty acid ester and like polyvalent alcohol-based nonionic surfactants; fatty acid alkanol amide; and polyoxypropylene-based nonionic surfactants and polyoxyethylene-polyoxypropylene copolymer-based nonionic surfactants both corresponding to the surfactants as exemplified above.

Among these surfactants, preferred for use in view of cleaning property are polyethylene glycol ether-based nonionic surfactants, and more preferable are those known and represented by the following formula

$$R-O-(CH_2CH_2O)_n-H \qquad (I)$$

wherein R is a $C_5$-$C_{20}$, preferably $C_{10}$-$C_{14}$, straight- or branched-chain alkyl group, a phenyl group or a phenyl group substituted with a $C_7$-$C_{12}$ straight- or branched-chain alkyl group, and n is an integer of 5 to 20, preferably 3 to 9.

The ratio of the component (A) to the component (B) is not specifically limited, but they are usually used in the ratio of (A) : (B) = about 95 to about 50 wt% : about 5 to about 50 wt%, preferably about 90 to about 80 wt% : about 10 to about 20 wt%.

Any one of the following three types of cleaning agents according to the present invention is used for removing rosin-base solder fluxes, particularly those for assembly:

(i) a cleaning agent (hereinafter referred to as "cleaning agent (1)") comprising a mixture of a nonionic surfactant and (a) a hydrogenated fraction obtained by hydrogenating a fraction which has a boiling point of 150 to 300°C and which is formed as a by-product in the thermal decomposition or reforming of petroleum naphtha and/or (b) a hydrocarbon fraction formed as a by-product in the preparation of a hydrogenated petroleum resin obtained by hydrogenating a petroleum resin which is prepared by subjecting to cationic polymerization a fraction having a boiling point of 150 to 300°C and formed as a by-product in the thermal decomposition or reforming of petroleum naphtha;

(ii) a cleaning agent (hereinafter referred to as "cleaning agent (2)") comprising a mixture of tetralin and a nonionic surfactant; and

(iii) a cleaning agent (hereinafter referred to as "cleaning agent (3)") comprising a mixture of a hydrogenation product of naphthalene oil fraction having a hydrogenation ratio of at least 20% and a nonionic surfactant.

Fluxes to be removed by the cleaning agent of the invention include inactive rosin fluxes consisting essentially of rosin, modified rosin or like rosin compound, and active rosin fluxes consisting essentially of such rosin compound and an activator such as triethanolamine hydrochloride, triethylene-tetramine hydrochloride, etc. Significant effect is produced by the cleaning agent of the invention especially when it is used for removing active fluxes for assembly.

The cleaning agent of the invention can be brought into contact with the rosin-base flux on a substrate by the following methods. The cleaning agent of the invention is used as it is, or in the form of an aqueous dispersion having a concentration of the active ingredients, i.e. a mixture of the components (A) and (B), in the range of more than about 50% by weight but less than 100% by weight. When required, the cleaning agent of the invention may contain additives such as defoaming agent, anti-corrosion agent or the like. Such additive, if used, is added in an amount of about 0.1 wt% or less based on the weight of the cleaning agent of the invention. The substrate may be directly immersed in the mixture serving as the active ingredients per se or in the aqueous dispersion thereof. Alternatively a mixture of the active ingredients per se or an aqueous dispersion of the active ingredients may be sprayed over the substrate to flush it therewith or may be brought into contact with the flux on brushing by mechanical means. A suitable method is selected from these methods.

The cleaning agent of the invention is applied under the conditions suitably determined according to the kind of a cleaning agent to be used, the kind and amount of a flux to be removed, surface area or shape of the substrate, and the like. Usually the cleaning agent of the invention is brought into contact with a flux at a temperature and for a period of time effective to remove the flux. The temperature for cleaning is usually in the range of room temperature to about 80°C, and is preferably around room temperature. For removal of a flux by the immersion method at a temperature, e.g. around room temperature, a substrate bearing a flux is immersed in the cleaning agent of the invention for about 1 to about 5 minutes, whereby the flux can be

4

eliminated effectively. The immersion at a higher temperature not exceeding the flash point of the cleaning agent, of course, can reduce the period of time for cleaning and can improve the cleaning efficiency.

Following the cleaning operation, the substrate is then washed with water as a finishing step, whereby the cleaning agent remaining on the substrate is completely washed away. Such rinsing leads to high level of cleanness.

Such rinsing can be carried out in various ways, such as, by dipping in running water, dipping in water under application of ultrasonic wave, spraying with water or the like. Rinsing is conducted at a temperature and for a period of time effective to remove the cleaning agent and to thereby achieve a high degree of cleanness. The rinsing is usually conducted at a temperature ranging from room temperature to about 70°C. When the rinsing is conducted by showering or dipping, the time required for completion of the rinsing is usually about 30 seconds to about 5 minutes. In any event, the rinsing is continued until the substrate becomes clean enough for a particular purpose.

The cleaning agent of the invention can exhibit a flux-removing effect higher than or at least as high as conventional halogenated hydrocarbon type cleaning agents and can accomplish a high degree of flux removal.

The present invention can additionally provide the following advantages.

(a) The cleaning agent of the invention is halogen-free and does not pose the ozone depletion problem as caused by flon-type cleaning agents. In particular, the cleaning agent (1) containing substantially no aromatic hydrocarbons is advantageous in that the agent (1) is relatively unlikely to cause the problem of air pollution.

(b) Although the cleaning agent (1) of the invention comprising the component (A)-(i) is flammable to some extent, the flash point of the agent can be elevated, as stated above, by eliminating the ingredients having a low flash point in the component (A)-(i). The cleaning agent thus made into a one having a flash point of at least about 70°C is classified as "a petroleum of the third kind" according to the Japanese Fire Services Act., so that a commercially available cleaning device designed for a flon can be employed as it is or as properly modified, eliminating the need for a specially designed explosion proof cleaning device.

Further, the cleaning agent (2) containing tetralin has a flash point of 77.2°C and the cleaning agent (3) containing the hydrogenation product of the naphthalene oil fraction has a flash point of about 80°C. In view of this, both of the cleaning agents (2) and (3) are classified as "petroleums of the third kind" according to the Japanese Fire Services Act., so that a commercially available cleaning device designed for a flon can be employed as it is or as properly modified, eliminating the need for a specially designed explosion proof cleaning device.

According to the invention, there are provided a halogen-free flux-cleaning agent outstanding in a cleaning property and fully satisfactory in properties meeting environmental quality standard, inflammability, etc. as well as a cleaning method using the cleaning agent.

The present invention will be described below in more detail with reference to the following reference examples and examples to which the scope of the invention is not limited. In the reference examples and examples, the "parts" and "percentages" are all by weight unless otherwise specified.

## Example 1

A 85 parts quantity of a hydrocarbon fraction (flash point of 35°C) formed as a by-product in the preparation of a $C_9$ hydrogenated petroleum resin was mixed with 15 parts of a polyethylene glycol alkyl ether nonionic surfactant (trade name "NOIGEN ET-135", product of Dai-ichi Kogyo Seiyaku Co., Ltd., a surfactant represented by the formula (I) wherein R is a $C_{12}$-$C_{14}$ branched chain alkyl group, and n is 9), giving a cleaning agent (1) of the present invention.

A rosin-base flux (trade name "Resin Flux #77-25", product of LONCO Co., Ltd.) was applied to the entire surface of a printed circuit board prepared from a copper-clad laminate and having thereon an exposed circuit portion and a non-circuit portion coated with a solder resist, dried at 130°C for 2 minutes and was subjected to soldering at 260°C for 5 seconds to produce a test board.

The test board was immersed for 1 minute in the foregoing cleaning agent at room temperature and the degree of removal of the flux was inspected with the unaided eye and evaluated according to the following criteria. Table 1 shows the results.

A : The flux was removed to a satisfactory extent.

B : A little quantity of the flux remained unremoved.

C : A considerable quantity of the flux remained unremoved.

Subsequently, the test board was washed with showering water and dried at room temperature for 30 seconds, and the cleanness (concentration of the residual ions) of the test board was determined according to MIL P28809 with use of an Omega-meter 600 SE (trade name for a product of KENKO Co., Ltd.). Table 1 shows the results.

Examples 2 and 3

The degree of removal of flux and the cleanness of the test board were evaluated in the same manner as in Example 1 with the exception of changing the ratio of the component (A)-(i) to the component (B) of the cleaning agent (1) as listed in Table 1. Table 1 shows the results.

Examples 4 to 6

The degree of removal of flux and the cleanness of the test board were evaluated in the same manner as in Example 1 with the exception of using each of the hydrocarbon fractions formed as a by-product in the preparation of a $C_9$ hydrogenated petroleum resin and having a flash point as shown in Table 1, or changing the cleaning temperature as shown in Table 1. Table 1 shows the results.

Example 7

The degree of removal of flux and the cleanness of the test board were evaluated by the same procedure as in Example 1 with the exception of using a hydrogenated fraction (flash point of 33°C) obtaiend by hydrogenating a fraction which had a boiling point of 150 to 300°C and which was formed as a by-product in the thermal decomposition of petroleum naphtha in place of the hydrocarbon fraction formed as a by-product in the preparation of a $C_9$ hydrogenated petroleum resin. Table 1 shows the results.

Examples 8 and 9

The degree of removal of flux and the cleanness of the test board were evaluated in the same manner as in Example 5 with the exception of changing the kind of the surfactant used as the component (B) to a polyethylene glycol dodecylphenyl ether nonionic surfactant (Example 8, trade name "NOIGEN EA-143", product of Dai-ichi Kogyo Seiyaku Co., Ltd., a surfactant represented by the formula (I) wherein R is dodecylphenyl, and n is 10), or to a polyethylene glycol nonylphenyl ether nonionic surfactant (Example 9, trade name "NOIGEN EA-120", product of Dai-ichi Kogyo Seiyaku Co., Ltd., a surfactant represented by the formula (I) wherein R is nonylphenyl, and n is 5). Table 1 shows the results.

6

Table 1

| | Composition of cleaning agent (1) | | | Cleaning temperature (°C) | Evaluation for degree of removal | Cleanness |
| | Flash point of component (a) (°C) | Flash point of component (b) (°C) | Comp. (a) or (b)/Comp. (B) (weight ratio) | | | Contamination of equivalent NaCl ($\mu$g/inch$^2$) |
|------|------|------|------|------|------|------|
| Ex.1 | - | 35 | 85/15 | Room temp. | A | 5.7 |
| Ex.2 | - | 35 | 90/10 | Room temp. | A | 5.2 |
| Ex.3 | - | 35 | 70/30 | Room temp. | A | 4.9 |
| Ex.4 | - | 49 | 85/15 | Room temp. | A | 5.1 |
| Ex.5 | - | 70 | 85/15 | 50 | A | 5.1 |
| Ex.6 | - | 90 | 85/15 | 50 | A | 5.3 |
| Ex.7 | 33 | - | 85/15 | Room temp. | A | 4.9 |
| Ex.8 | - | 49 | 85/15 | Room temp. | A | 5.2 |
| Ex.9 | - | 49 | 85/15 | Room temp. | A | 5.2 |

Reference Example 1

An autoclave was charged with 100 parts of a naphthalene oil fraction (boiling point of 200 to 250°C) and 5 parts of a hydrogenation catalyst (Pd-alumina) and the mixture was subjected to hydrogenation under a hydrogen pressure of 70 atm at 100°C for 5 hours, giving a hydrogenation product of the naphthalene oil fraction. The hydrogenation product obtained had a boiling point of 180 to 230°C, a flash point of 72°C and a hydrogenation ratio of 54%.

Example 10

A 90 parts quantity of tetralin was mixed with 10 parts of a polyethylene glycol alkyl ether nonionic surfactant (trade name "NOIGEN ET-135", product of Dai-ichi Kogyo Seiyaku Co., Ltd.), giving a cleaning agent (2) of the present invention.

A rosin-base flux (trade name "Resin Flux #77-25", product of LONCO Co., Ltd.) was applied to the entire surface of a printed circuit board prepared from a copper-clad laminate and having thereon an exposed circuit portion and non-circuit portion coated with a solder resist, dried at 130°C for 2 minutes and was subjected to soldering at 260°C for 5 seconds to produce a test board.

The test board was immersed for 1 minute in the foregoing cleaning agent at room temperature and the degree of removal of the flux was inspected with the unaided eye and evaluated according to the following criteria. Table 2 shows the results.

A : The flux was removed to a satisfactory extent.

B : A little quantity of the flux remained unremoved.

C : A considerable quantity of the flux remained unremoved.

Subsequently, the test board was washed with showering water and dried at room temperature for 30 seconds, and the cleanness (concentration of the residual ions) of the test board was determined according to MIL P 28809 with use of an Omega-meter 600 SC (trade name for a product of KENKO Co., Ltd.). Table 2 below shows the results.

Examples 11 and 12

The degree of removal of flux and the cleanness of the test board were evaluated in the same manner as in Example 10 with the exception of changing the composition of the cleaning agent or the temperature during the immersion of the test board in the cleaning agent as shown in Table 2. Table 2 shows the results.

Examples 13 and 14

The degree of removal of flux and the cleanness of the test board were evaluated by the same procedure as in Example 10 with the exception of using a polyethylene glycol dodecylphenyl ether nonionic surfactant (Example 13, trade name "NOIGEN EA-143", product of Dai-ichi Kogyo Seiyaku Co., Ltd.) and a polyethylene glycol nonylphenyl ether nonionic surfactant (Example 14, trade name "NOIGEN EA-120", product of Dai-ichi Kogyo Seiyaku Co., Ltd.). The results are shown in Table 2.

Example 15

A 90 parts quantity of the hydrogenation product of naphthalene oil fraction obtained in Reference Example 1 was mixed with 10 parts of NOIGEN ET-135, giving a cleaning agent (3) of the present invention. The foregoing performance of the cleaning agent was evaluated in the same manner as in Example 10. Table 2 shows the results.

## Examples 16 and 17

The degree of removal of flux and the cleanness of the test board were evaluated in the same manner as in Example 15 with the exception of changing the ratio of the component (A) to the component (B) for preparing the cleaning agent (3) as shown in Table 2, or changing the temperature during the immersion of the test board in the cleaning agent as shown in Table 2. Table 2 shows the results.

## Examples 18 and 19

The performance of the cleaning agent was evaluated by the same procedure as in Example 15 with the exception of changing the kind of the surfactant, i.e., component (B) to NOIGEN EA-143 (Example 18) and to NOIGEN EA-120 (Example 19), respectively. Table 2 shows the results.

Table 2

| | Composition of cleaning agent | Cleaning temperature ($^\circ$C) | Evaluation for degree of removal | Cleanness |
|---|---|---|---|---|
| | Component (A) / Component (B) (ratio by weight) | | | Contamination of equivalent NaCl ($\mu$g/inch$^2$) |
| Example 10 | 90/10 | Room temp. | A | 5.7 |
| Example 11 | 70/30 | Room temp. | B | - |
| Example 12 | 70/30 | 50 | A | 5.1 |
| Example 13 | 90/10 | Room temp. | A | 5.1 |
| Example 14 | 90/10 | Room temp. | A | 5.2 |
| Example 15 | 90/10 | Room temp. | A | 5.9 |
| Example 16 | 70/30 | Room temp. | B | - |
| Example 17 | 70/30 | 50 | A | 5.5 |
| Example 18 | 90/10 | Room temp. | A | 5.5 |
| Example 19 | 90/10 | Room temp. | A | 5.7 |

Examples 10 to 14 : Comonent (A) = tetralin

Examples 15 to 19 : Component (A) = hydrogenation product of naphthalene oil fraction obtained in Reference Example 1

## Claims

1. A cleaning agent for removal of a rosin-base solder flux, the cleaning agent comprising a mixture of
    (A) one of the following components (i) to (iii):
        (i) (a) a hydrogenated fraction obtained by hydrogenating a fraction which has a boiling point of 150 to 300$^\circ$C and which is formed as a by-product in the thermal decomposition or reforming of petroleum naphtha and/or (b) a hydrocarbon fraction formed as a by-product in the preparation of a hydrogenated petroleum resin obtained by hydrogenating a petroleum resin which is prepared by subjecting to cationic polymerization a fraction having a boiling point of 150 to 300$^\circ$C and formed as a by-

9

product in the thermal decomposition or reforming of petroleum naphtha,

(ii) tetralin, and

(iii) a hydrogenation product of a naphthalene oil fraction having a hydrogenation ratio of at least 20%; and

(B) a nonionic surfactant.

2. A cleaning agent according to claim 1 wherein the component (B) is a nonionic surfactant represented by the formula

R-O-(CH$_2$CH$_2$O)$_n$-H    (I)

wherein R is a straight- or branched-chain alkyl group having 5 to 20 carbon atoms, a phenyl group or a phenyl group substituted with a straight- or branched-chain alkyl group having 7 to 12 carbon atoms, and n is an integer of 5 to 20.

3. A cleaning agent according to claim 1 or 2 wherein the mixture comprises about 95 to about 50% by weight of the component (A) and about 5 to about 50% by weight of the component (B), preferably about 90 to about 80% by weight of the component (A) and about 10 to about 20% by weight of the component (B).

4. A cleaning agent according to any one of claims 1-3 which further contains water.

5. A cleaning agent according to claim 4 which contains the mixture at a concentration of more than about 50% by weight but less than 100% by weight.

6. A cleaning method for removing a rosin-base solder flux, characterized by bringing a cleaning agent into contact with the rosin-base solder flux on a substrate, the cleaning agent comprising a mixture of

(A) one of the following components (i) to (iii):

(i) (a) a hydrogenated fraction obtained by hydrogenating a fraction which has a boiling point of 150 to 300°C and which is formed as a by-product in the thermal decomposition or reforming of petroleum naphtha and/or (b) a hydrocarbon fraction formed as a by-product in the preparation of a hydrogenated petroleum resin obtained by hydrogenating a petroleum resin which is prepared by subjecting to cationic polymerization a fraction having a boiling point of 150 to 300°C and formed as a by-product in the thermal decomposition or reforming of petroleum naphtha,

(ii) tetralin, and

(iii) a hydrogenation product of naphthalene oil fraction having a hydrogenation ratio of at least 20%; and

(B) a nonionic surfactant.

7. A cleaning method according to claim 6 wherein the component (B) is a nonionic surfactant represented by the formula

R-O-(CH$_2$CH$_2$O)$_n$-H    (I)

wherein R is a straight- or branched-chain alkyl group having 5 to 20 carbon atoms, a phenyl group or a phenyl group substituted with a straight- or branched-chain alkyl group having 7 to 12 carbon atoms, and n is an integer of 5 to 20.

8. A cleaning method according to claim 6 or 7 wherein the mixture comprises about 95 to about 50% by weight of the component (A) and about 5 to about 50% by weight of the component (B), preferably about 90 to about 80% by weight of the component (A) and about 10 to about 20% by weight of the component (B).

9. A cleaning method according to any one of claims 6-8 wherein the cleaning agent further contains water.

10. A cleaning method according to claim 9 wherein the cleaning agent contains the mixture at a concentration of more than about 50% by weight but less than 100% by weight.

11. A cleaning method according to any one of claims 6-10 wherein the cleaning agent is brought into contact with the rosin-base solder flux on the substrate for a time period and at a temperature effective for removal of the flux.

12. A cleaning method according to claim 11 wherein the cleaning agent is brought into contact with the flux at a temperature around room temperature.

13. A cleaning method according to any one of claims 6-12 which further comprises the step of washing the substrate with water.

## DOCUMENTS CONSIDERED TO BE RELEVANT

EP 90111021.3

| Category | Citation of document with indication, where appropriate, of relevant passages | Relevant to claim | CLASSIFICATION OF THE APPLICATION (Int. Cl.5) |
|---|---|---|---|
| A | US - A - 4 640 719 (M.E. HAYES et al.) * Claim 1 * -- | 1 | C 11 D 7/24 C 11 D 3/18 C 11 D 3/43 C 11 D 7/50 B 23 K 35/00 |
| A | EP - A1 - 0 351 810 (DU PONT) * Claim 1 * -- | 1 | |
| A | N. SCHÖNFELDT "Grenzflächenaktive Äthylendioxid-Addukte" 1st edition, 1976, Stuttgart WISSENSCHAFTLICHE VERLAGS-GESELLSCHAFTMBH pages 52-58 * Page 57, table 7 * ---- | 1,2 | |

TECHNICAL FIELDS SEARCHED (Int. Cl.5)

C 11 D
B 23 K 35/00

The present search report has been drawn up for all claims

| Place of search | Date of completion of the search | Examiner |
|---|---|---|
| VIENNA | 16-10-1990 | SEIRAFI |